(19) Europäisches Patentamt
European Patent Office
Office européen des brevets

(11) **EP 3 154 099 A1**

(12) **EUROPEAN PATENT APPLICATION**

(43) Date of publication:
**12.04.2017 Bulletin 2017/15**

(51) Int Cl.:
*H01L 41/09* (2006.01)    *H01L 41/00* (2013.01)
*H02N 2/18* (2006.01)     *H01L 41/187* (2006.01)
*H01L 41/18* (2006.01)

(21) Application number: **15382491.7**

(22) Date of filing: **09.10.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicants:
• **Institut Català de Nanociència i Nanotecnologia 08193 Barcelona (ES)**

• **Institució Catalana de Recerca i Estudis Avaniçats ICREA 08010 Barcelona (ES)**

(72) Inventors:
• **CATALÁN BERNABÉ, Gustau 08172 Sant Cugat del Vallès (ES)**
• **NARVÁEZ MORALES, Jackeline 08290 Cerdanyola del Vallès (ES)**

(74) Representative: **Carvajal y Urquijo, Isabel et al Clarke, Modet & Co. Suero de Quiñones, 34-36 28002 Madrid (ES)**

(54) **FLEXOELECTRIC DEVICE**

(57)    Flexoelectric device (1) which comprises an electromechanically active layer (2) made of a semiconductor material inserted between two metallic electrodes (3, 4), which is capable of generating a voltage (V) between the two electrodes (3, 4) when it is bent.

Fig. 3A

**Description**

FIELD OF THE INVENTION

The present invention relates to the field of electromechanical transducers (including sensors, actuators and microelectromechanical systems) and more specifically to a device based on the flexoelectric effect that converts a bending motion into a voltage, or vice versa.

BACKGROUND ART

The technology's closest relatives to the present invention are the piezoelectric bimorph cantilevers. These devices convert an electrical voltage into a bending deformation, or a bending deformation into a voltage. As a necessary requirement for the correct functioning of bimorph cantilevers, the piezoelectric elements are either clamped to a non-piezoelectric elastic layer, or to each other but in anti-parallel orientation of the piezoelectric coefficient. In the first case, when the cantilever is bent downward, the piezoelectric layer at the top is stretched, and generates a piezoelectric voltage. In the second case, the piezoelectric layer at the bottom is compressed, generating an equal voltage to the one at the top and thus doubling the performance. The charge generated by the piezoelectric layers is collected by electrodes. Additionally, inertial masses may be added at the tip of the cantilever so as to amplify the amplitude of the vibration-induced oscillations in the cantilever.

The requisite that the piezoelectric element be clamped to either a non-piezoelectric layer or a piezoelectric layer with opposite polarity comes from the fact that bending does not produce any net expansion or contraction of the average length of the cantilever, and piezoelectric voltage can only be generated when there is a net stretching or compression of the piezoelectric layer. Bending, however, does produce a stretching of the convex side and a compression of the concave side of the cantilever. So, if a piezoelectric layer is attached to only one of the sides of a cantilever (first case), or piezoelectric layers are attached to opposite sides of a cantilever but with opposite signs of the piezoelectric coefficient (second case), then bending the cantilever will result in a net compression (expansion) of the piezoelectric on the concave (convex) side, thus allowing the piezoelectric to actually generate a voltage in response to the mechanical bending of the cantilever.

The aforementioned technology is mature and widely used in applications where one needs to convert vibrations/mechanical energy into a voltage or, vice versa, converting a voltage into a bending motion.

Nonetheless, piezoelectric bimorph cantilevers have a series of drawbacks that are detailed below.

- The materials with highest piezoelectric coefficients are ferroelectric, and are often oxides and/or lead-based materials. This is inconvenient because; (i) ferroelectrics are, by definition, non-linear, in the sense that their response is hysteretic, they are prone also to fatigue and/or depolarization; (ii) ferroelectrics cease to function at temperatures above their Curie Temperature (Tc) and if they accidentally get heated above Tc they also cease to work properly even when they are cooled back down, due to the random reconfiguration of the polar domains; (iii) lead-based ferroelectrics (the best known and most frequently used is lead-zirconate titanate, PZT) have extremely high piezoelectric coefficients and can yield very large bendings, but they contain a toxic element (lead), and there is a strong regulatory incentive to progressively get rid of all lead content in electronic devices -particularly those related to biomedical applications. In addition, growing PZT and/or other perovskite piezoelectrics on silicon (the standard platform for most electronic device applications) is technologically complex.

- Because of the aforementioned drawbacks, the most widely used piezoelectric in Si-compatible bimorph applications is aluminium nitride (AIN). The inconvenient of this material, however, is that its piezoelectric coefficient is about two orders of magnitude smaller than that of PZT.

- The use of bimorph structures introduces severe mechanical stresses at the interface between the piezoelectric and the non-piezoelectric layer, and this can lead to delamination and/or progressive mechanical degradation.

All of these above problems can be solved by exploiting flexoelectricity instead of piezoelectricity. Flexoelectricity is a physical property of materials (dielectric insulators mainly) whereby they generate a voltage when they are bent, while converse flexoelectricity is the inverse mechanism, whereby materials bend when they are subject to a voltage.

All flexoelectric devices have two electrodes and a dielectric material inserted between them. When subject to an inhomogeneous deformation (strain gradient), such as bending, the dielectric material will polarize and generate a charge density at its surface. The role of the electrodes is to collect this charge. The figure of merit of such a device is the effective flexoelectric coefficient, $\mu_{eff}$, which is the coefficient between the generated charge and the applied strain gradient. This coefficient measures the amount of charge (in Coulombs) generated per unit bending (curvature measured in m$^{-1}$). The flexoelectric coefficient of most materials is in the nC/m ($10^{-9}$ C/m) range, and only occasionally can reach up to a few $\mu$C/m ($10^{-6}$ C/m).

The best flexoelectric materials reported so far are lead free [L.E. Cross; "Flexoelectric effects: Charge separation in insulating solids subjected to elastic strain gradients", J. Mater. Sci. 41, 53-63 (2006)] and [P. Zubko, G. Catalan and A. K. Taganstsev; Flexoelectric Effect in Solids, Ann. Rev. Mater. Res. 43 (2013)]. This means that toxicity issues can be removed. Moreover, ferroelectricity is not a requirement, and therefore the inherent non-linearity (hysteresis), fatigue and temperature limitations of ferroelectrics can be removed from flexoelectric devices.

Likewise, as any dielectric must be flexoelectric, it is in principle possible to choose from an almost infinite palette of materials. Finally, flexoelectricity generates a voltage by bending without the need for bimorph structures. Thus, interfacial stress and delamination issues are also removed.

The key disadvantage of flexoelectricity when compared with piezoelectricity as a mechanism for converting deformation into electricity is that the amount of charge that can be generated by pure flexoelectric means is generally small compared to that which can be generated by piezoelectric means. Typical flexoelectric coefficients are of the order of a few nC/m (nano-Coulomb per meter, $10^{-9}$ C m$^{-1}$), sometimes even smaller. The largest flexoelectric coefficients have been measured in barium titanate (BaTiO$_3$) and barium-strontium titanate ((Ba, Sr)TiO$_3$) and are of the order of a few $\mu$C/m (micro-Coulomb per meter, $10^{-6}$ C m$^{-1}$). A piezoelectric bimorph subject to the same strain gradients as a "normal" flexoelectric will normally generate much more charge.

The present invention relates to the use of semiconductors instead of dielectrics inside flexoelectric devices. This achieves much larger effective flexoelectric coefficients, in the order of mC/m (mili-Coulomb per meter, $10^{-3}$ C m$^{-1}$), which are about a million times bigger than the flexoelectric coefficients of standard insulating dielectrics, and bring the performance of semiconductor flexoelectric devices up to the same quantitative level as that of piezoelectrics.

## SUMMARY OF THE INVENTION

In order to achieve the mentioned flexoelectric coefficients, the present invention proposes a new flexoelectric device in which the dielectric layer (electrically insulating layer) is substituted for a semiconductor layer (electrically conducting layer).

Thus, the flexoelectric device of the present invention comprises:

- an electromechanically active layer (or flexoelectric layer) with a first side and a second side;
- a first electrode arranged on the first side; and
- a second electrode arranged on the second side.

The electromechanically active layer is made of a semiconductor material capable of generating a voltage between the two electrodes when it is bent. That is, any semiconductor material, for example; silicon, n-type or p-type doped silicon, etc. The use of semiconductors instead of dielectrics as flexoelectrically active materials is the object of the present invention.

This semiconductor layer can spontaneously (or naturally) form charge-depleted insulating barriers, such as a Schottky barriers, at the interfaces with the electrodes. Such insulating barrier layers may also be induced by adequate doping.

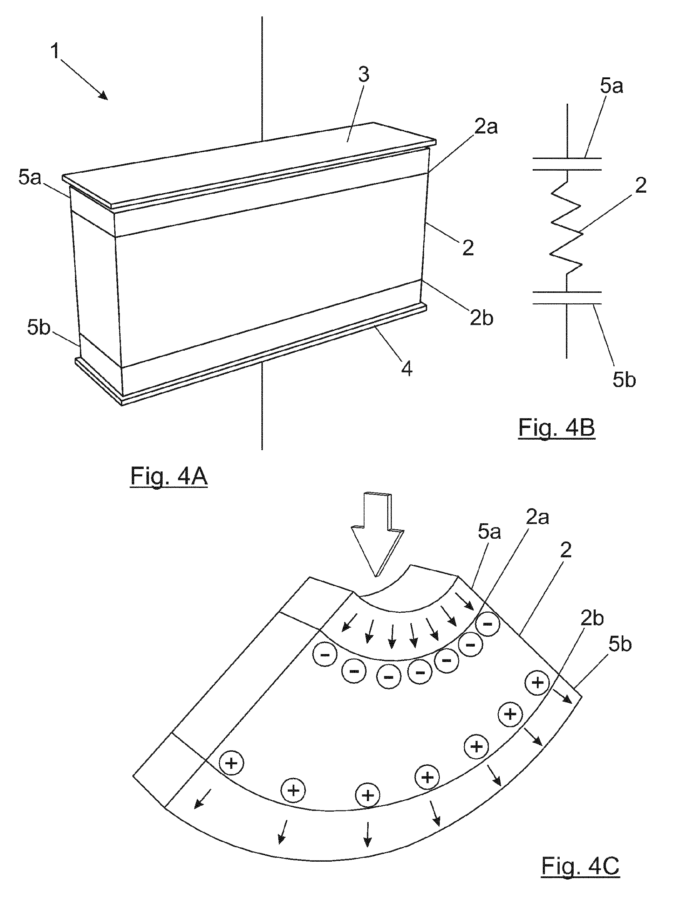

The idea behind the flexoelectric enhancement of semiconductors is exploiting the so-called barrier layer or Maxwell-Wagner capacitor effect, depicted in Fig. 4C. Semiconductor materials can present charge-depleted insulating interfaces (barrier layers, Schottky barriers) with the electrodes. When a low-frequency field (either electric field or mechanical stress) is applied to such semiconductor capacitors with barrier layers, the conducting core of the crystal responds by allowing free charges to move across, thus effectively behaving as an intercalated electrode. In this scenario, only the thin barrier layers at the interface contribute to the total capacitance and, because capacitance is inversely proportional to thickness, colossal capacitance is achieved [A. Von Hippel. Dielectrics and Waves, London: Artech House, (1995)], [D. O'Neill, R. M. Bowman, J. M. Gregg; "Dielectric enhancement and Maxwell-Wagner effects in ferroelectric superlattice structures", Appl. Phys. Lett. 77, 1520 (2000)], [G. Catalan, J. F. Scott. "Magnetoelectrics-Is CdCr2S4 a multiferroic relaxor?" Nature 448 (7156), E4-E5 (2007)], [Derek C. Sinclair, Timothy B. Adams, Finlay D. Morrison, and Anthony R. West; "CaCu3Ti4O12: One-step internal barrier layer capacitor", Appl. Phys. Lett. 80, 2153 (2002)] and [R. M. Glaister; "Barrier-layer dielectrics", Proceedings of the IEE - Part B: Electronic and Communication Engineering, Volume 109, p. 423 - 431 (1962)].

Like the giant capacitance or giant effective permittivity discussed in the previous paragraph, ultra-large effective flexoelectricity can also be achieved by exploiting the barrier layer effect in semiconductor capacitor structures. This can be understood using phenomenological arguments: it is known that flexoelectricity is directly proportional to permittivity [P. Zubko, G. Catalan and A. K. Taganstsev; "Flexoelectric Effect in Solids", Ann. Rev. Mater. Res. 43 (2013)], and capacitance is directly proportional to permittivity, so any mechanism that gives giant capacitance (such as the Maxwell-Wagner mechanism) must also result in giant flexoelectricity.

On a microscopic level, it is known that bending always generates at least two electromechanical responses of comparable magnitude: the bulk flexoelectric polarization, and a surface piezoelectric polarization [E. V. Bursian, N.N. Trunov; "Nonlocal piezoelectric effect", Sov. Phys. Sol. State 16, 760 (1974)], [P. Zubko, G. Catalan and A. K. Taganstsev; "Flexoelectric Effect in Solids", Ann. Rev. Mater. Res. 43 (2013)], [A.K. Tagantsev, A.S. Yurkov; "Flexoelectric effect in finite samples", J. Appl. Phys. 112, 044103 (2012)] and [M. Stengel; "Microscopic response to inhomogeneous deformations in curvilinear coordinates", Nature Communications 4, 2693 (2014)] caused by the straining of the opposite surface layers (compression on the concave side, tension on the convex side). The existence of surface piezoelectricity is itself universally guaranteed, because it is a necessary consequence of the fact that interfaces are intrinsically asymmetric: the material above the interface is, by definition of interface, different from that below, and asymmetry is a necessary and sufficient condition for piezoelectricity to exist. The combination of bulk conductivity with interfacial insulation and piezoelectricity has two consequences:

(i) The bulk polarization will be screened by free charges [Y. A. Genenko, O. Hirsch and P. Erhart; "Surface potential at a ferroelectric grain due to asymmetric screening of depolarization fields, J. Appl. Phys. 115, 104102 (2014)] and [M. Stengel; "Microscopic response to inhomogeneous deformations in curvilinear coordinates", Nature Communications 4, 2693 (2014)], so it does not contribute to the total polarization.

(ii) The free charges also help screen the polar discontinuity between the surface layer and the bulk of the crystal, thus increasing the actual piezoelectric polarization that can be generated at the surface. In effect, the system behaves as if there were two piezoelectric layers attached to the opposite surfaces of a conducting slab that acts as an intercalated electrode. It mimics, in this respect, the structure of some heteromorph piezoelectric actuators and can therefore achieve a performance as high as that of piezoelectrics.

In this scenario, the bending-induced charge density is just the product of the surface piezoelectric coefficient (e) times the surface strain, while the surface strain itself is the product of the curvature (the strain gradient, G) times the half-thickness of the crystal, $t/2$. Thus, the bending-induced surface polarization is

$$ P = eG\frac{t}{2} \qquad (1) $$

The effective flexoelectric coefficient is defined as the polarization divided by the strain gradient G; therefore:

$$ \mu_{eff} = e\frac{t}{2} \qquad (2) $$

Here, two things are remarked:

1) The effective flexoelectric coefficient in equation (2) is proportional to the thickness of the crystal, and therefore the effective flexoelectricity that can be extracted from semiconductors can be large for macroscopic samples.

2) A large effective flexoelectricity can be obtained even for fairly small values of the surface piezoelectric coefficient, e. To illustrate this, equation (2) is used. For a semiconducting crystal with a thickness of 1mm, and a surface-piezoelectric coefficient e=0.2 C/m$^2$ (this is the piezoelectric coefficient of quartz, which is about 100-1000 times smaller than that of good PZT ceramics), it is already obtained $\mu_{eff}$=10$^{-4}$C/m$^2$=100$\mu$C/m, which is already extremely high by flexoelectric standards. For a surface-piezoelectric coefficient 100 times bigger, which would be comparable to the piezoelectric coefficient of ceramics such as PZT or BST (Barium strontium titanate), then the efective flexoelectricity is 10mC/m, an unprecedentedly huge value. Our own measurements in paraelectric BaTiO$_3$ crystals, reduced to make them conducting, yield effective flexoelectric values of 1 mC/m.

The present invention therefore proposes that using semiconductors instead of dielectrics in a flexoelectric device will yield an orders-of-magnitude improvement in performance. Moreover, because silicon is a semiconductor, flexoelectric devices can be made using silicon as the electromechanically active layer.

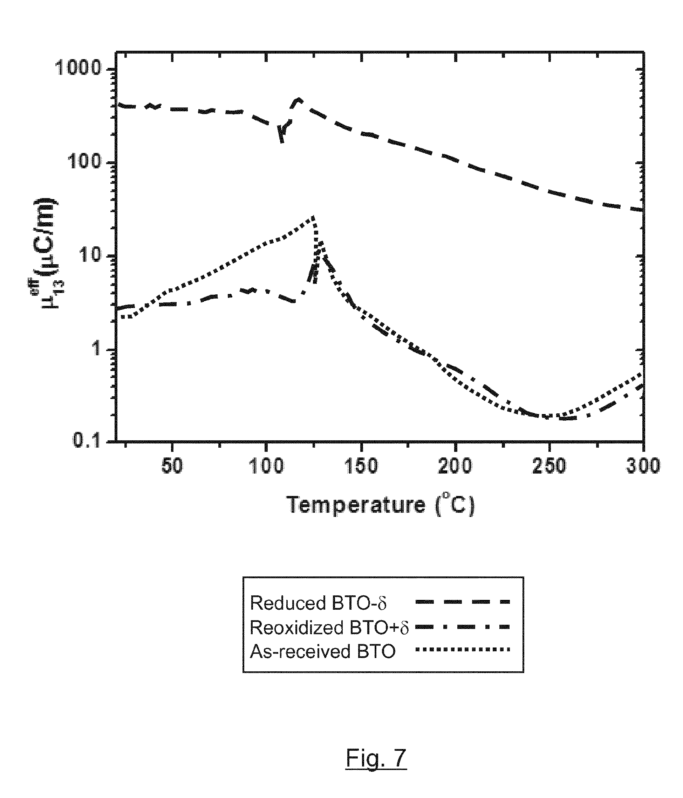

This concept has been demonstrated with an embodiment of the semiconductor flexoelectric device of the present invention. Specifically, using a cantilever capacitor structure where the electromechanically active layer is barium titanate (BTO), oxygen-reduced in order to create oxygen vacancies that act as electron donors thus turning this material into an n-type semiconductor [W. Heywang; "Semiconducting Barium Titanate", J. Mater. Science. 6, 1214 (1971)] and [T. Kolodiazhnyi, A. Petric, M. Niewczas, C. Bridges, A. Safa-Sefat, and J. E. Greedan; "Thermoelectric power, Hall effect, and mobility of n-type BaTiO3", Phys. Rev. B 68, 085205 (2003)] with charge-depleted surfaces [Y. A. Genenko, O. Hirsch and P. Erhart; "Surface potential at a ferroelectric grain due to asymmetric screening of depolarization fields", J. Appl. Phys. 115, 104102 (2014)] and [T. Kolodiazhnyi, A. Petric, M. Niewczas, C. Bridges, A. Safa-Sefat, and J. E. Greedan; "Thermoelectric power, Hall effect, and mobility of n-type BaTiO3", Phys. Rev. B 68, 085205 (2003)]. The combination of high conductivity and interfacial charge depletion leads to an enormous enhancement of effective permittivity and also of flexoelectricity, yielding the highest effective flexoelectric coefficient ever measured, as shown in the figure 7. In said figure, the flexoelectric coefficient of the reduced (semiconducting) BTO is compared with that of the same sample but in a fully oxidized (insulating) material: the results show that the semiconducting state has 100 times more flexoelectricity than the insulating one.

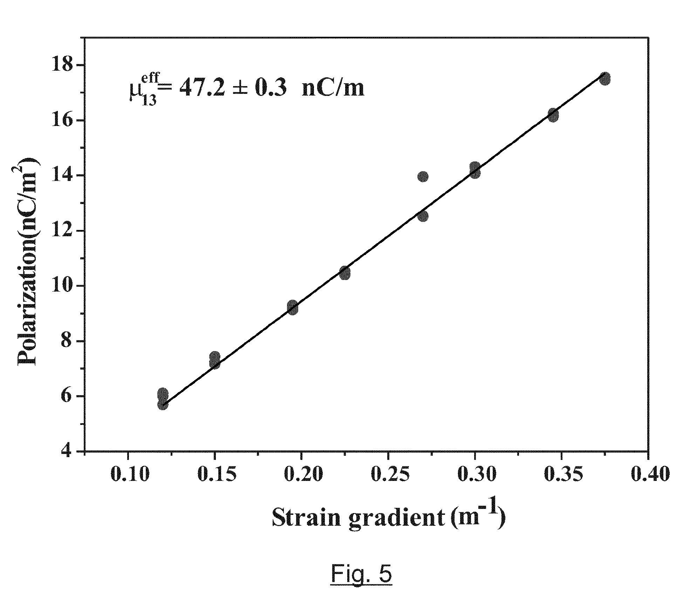

Another embodiment of the present invention uses a cantilever capacitor structure (electrode/semiconductor/electrode) where the electromechanically active semiconductor layer is silicon (figure 5). This yielded flexoelectric coefficients of the order of 50nC/m; this is smaller than for doped BTO, but it is still ten times bigger than those of the archetypal dielectric $SrTiO_3$, with the advantage that silicon is by far the most widely available and easy to manufacture material in the electronics industry.

BRIEF DESCRIPTION OF THE DRAWINGS

A series of drawings which aid in better understanding the invention and which are expressly related with several embodiments of said invention, presented as a nonlimiting examples thereof, are very briefly described below.

Fig. 1A shows a schematic view of a standard bimorph piezoelectric device.

Fig. 1 B shows a cross-sectional view of the device of Fig. 1A.

Fig. 2A shows a schematic view of the capacitor structure of a conventional flexoelectric bending device based on a dielectric material.

Fig. 2B shows the equivalent circuit of the device of Fig. 2A.

Fig. 2C shows the electromechanical response of the device of Fig. 2A.

Fig. 3A shows a schematic view of a flexoelectric bending device according to a preferred embodiment of the present invention.

Fig. 3B shows a cross-sectional view of the device of Fig. 3A.

Fig. 4A shows a schematic view of the capacitor structure of a flexoelectric bending device based on a semiconductor material, according to the present invention.

Fig. 4B shows the equivalent circuit of the device of Fig. 4A.

Fig. 4C shows the electromechanical response of the device of Fig. 4A.

Fig. 5 shows a graph representing the bending-induced polarization of a Pt-Si-Pt cantilever as a function of the induced curvature, according to a second embodiment of the present invention.

Fig. 6 shows a graph representing the relative dielectric constant and the dielectric loss as a function of the temperature, for fully oxidized barium titanate (BTO), oxygen-reduced barium titanate ($BTO_{-\delta}$) and re-oxidized barium titanate ($BTO_{+\delta}$), according to a third embodiment of the present invention.

Fig. 7 shows a graph representing the effective flexoelectric coefficient as a function of the temperature, for fully oxidized barium titanate (BTO), oxygen-reduced barium titanate ($BTO_{-\delta}$) and re-oxidized barium titanate ($BTO_{+\delta}$), according to the third embodiment of the present invention.

DESCRIPTION OF A PREFERRED EMBODIMENT OF THE INVENTION

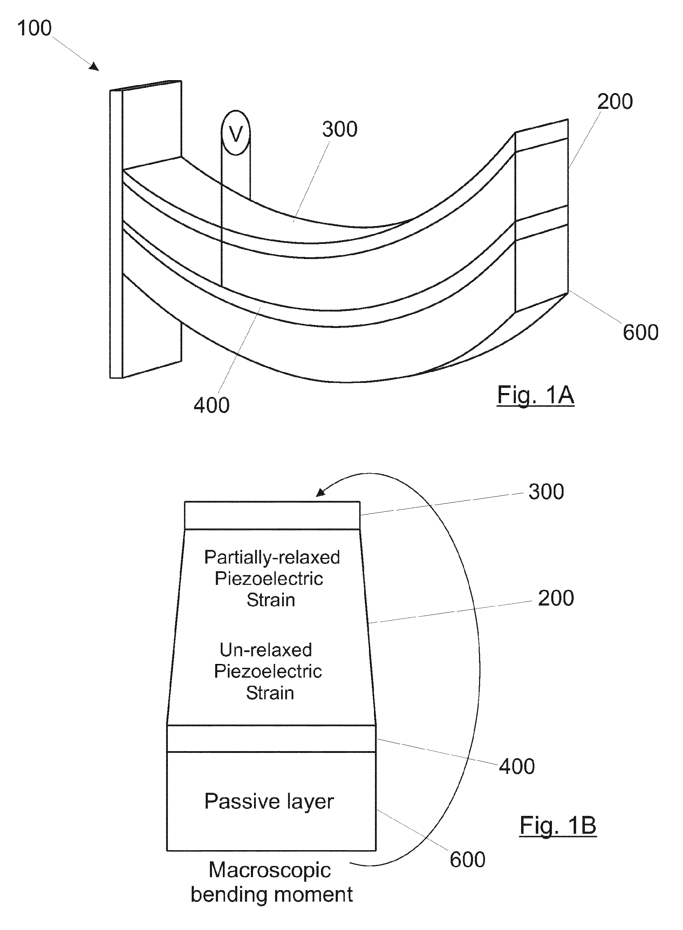

Fig. 1A shows a standard piezoelectric bimorph cantilever (100), capable of converting a bending motion into a voltage or, vice versa, a voltage into a bending motion. In order to ensure that there is a net voltage in response to bending, or a net bending in response to voltage, it is necessary the presence of two structural layers (200, 600). The first structural layer (200), or electromechanically active layer, is made of a piezoelectric material sandwiched between two electrodes (300, 400), whereas the second structural layer (600) is made of a non-piezoelectric elastic material. It is worth noting that the active layer limits considerably the range of materials that can be used for this type of devices.

Fig. 1 B shows the internal deformation mechanism of this piezoelectric device (100). It is noted that the only layer that is actively trying to deform is the piezoelectric one, while the elastic layer tries to prevent such deformation; this is necessary in order to achieve bending, but it also results in high stresses at the interface between the two layers, with risk of delamination.

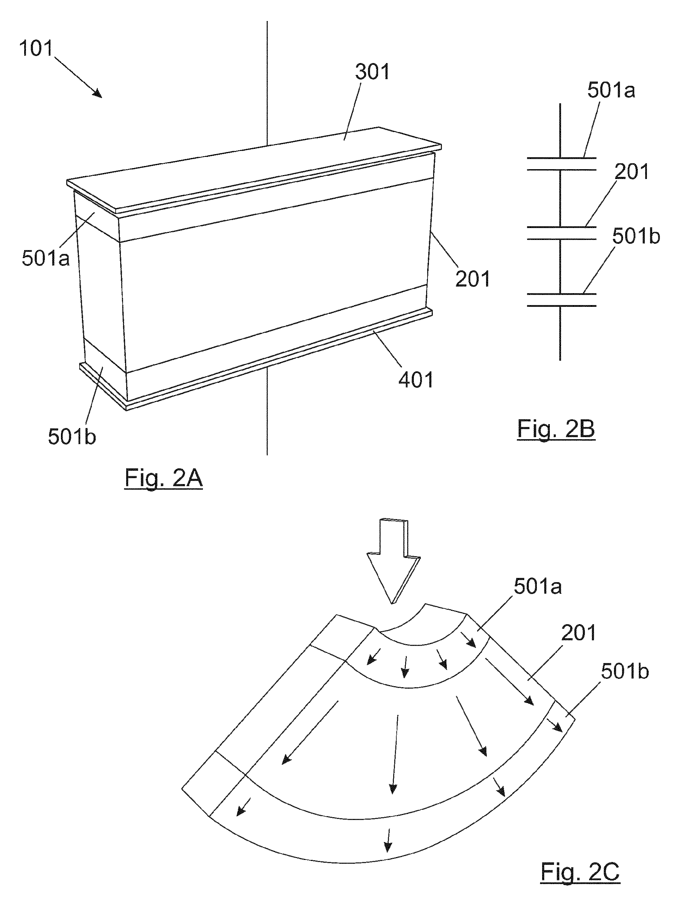

Fig. 2A shows a conventional flexoelectric bending transducer based on a dielectric material. The structural layer (201), or electromechanically active layer, of this device (101) is composed of a simple dielectric, or bulk of the crystal, with insulating interfacial barriers (501 a, 501 b). Thus, this device (101) acts as a capacitor connected in series (see Fig 2B). The amount of flexoelectric charge that such a crystal can generate when it is bent is proportional to its capacitance, which is inversely proportional to the thickness of the crystal and is therefore small for macroscopically thick devices. The electromechanical response of this device (101) can appreciated in Fig. 2C.

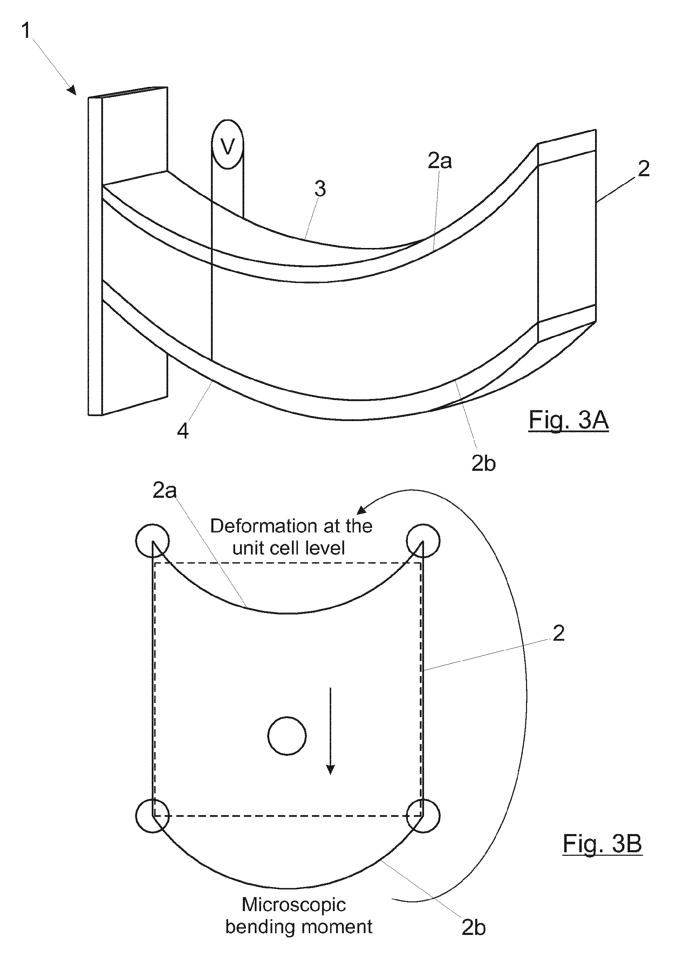

Fig. 3A shows a flexoelectric device (1) according to a preferred embodiment of the present invention. As it can be appreciated, the flexoelectric device (1) comprises:

- a single electromechanically active layer (2), with a first side (2a) and a second side (2b) opposite to the first side (2a);

- a first electrode (3) arranged on the first side (2a); and

- a second electrode (4) arranged on the second side (2b).

The electromechanically active layer (2) is made of a semiconductor material capable of generating a voltage (V) between the two electrodes (3, 4) when it is bent, or vice versa, bending in response to a voltage (V).

Fig. 3B shows the internal deformation mechanism of this flexoelectric device (1).

As it can be appreciated in Fig. 4A, the flexoelectric device (1) of the present invention comprises an electromechanically active layer (2) that is not dielectric but instead it is a semiconductor material sandwiched between two metallic electrodes (3, 4). This semiconductor layer (2) spontaneously forms a first charge-depleted insulating barrier (5a) between the first side (2a) and the first electrode (3), and a second charge-depleted insulating barrier (5b) between the second side (2b) and the second electrode (4). The surface of the electromechanically active layer (2), or sides (2a, 2b), remains insulating because any semiconductor in contact with a metal spontaneously develops a charge-depleted interfacial region. In this scenario, the equivalent circuit is a resistor (thick core of the crystal) in series with two very thin interfacial capacitors (see Fig 4B). The equivalent capacitance of this circuit is much larger and so is, therefore, the charge that can be flexoelectrically generated. It is worth noting that this active layer widens the range of materials that can be used for this type of devices to any semiconductor material, for example: silicon, n-type or p-type doped silicon, etc.

The electromechanical response of this flexoelectric device (1) is schematically depicted in Fig. 4C. As it can be appreciated, the surface piezoelectric polarization of Fig. 2C is enhanced thanks to the minimization of depolarization due to the conducting bulk.

According to another embodiment of the present invention, the flexoelectric device (1) has a cantilever-shaped capacitor structure formed by a doped single-crystal silicon wafer with platinum electrodes (3, 4) deposited onto the opposite sides of said wafer or electromechanically active layer (2). The graph of Fig. 5 has been obtained from a flexoelectric device (1) of this kind, having a dimensions of 1 cm long, 2 mm wide and 1 mm thick. The effective flexoelectric coefficient of this silicon capacitor structure is approximately 50nC/m. This is ten times bigger than the flexoelectric coefficient of insulating strontium titanate ($SrTiO_3$), the standard reference for dielectric flexoelectricity.

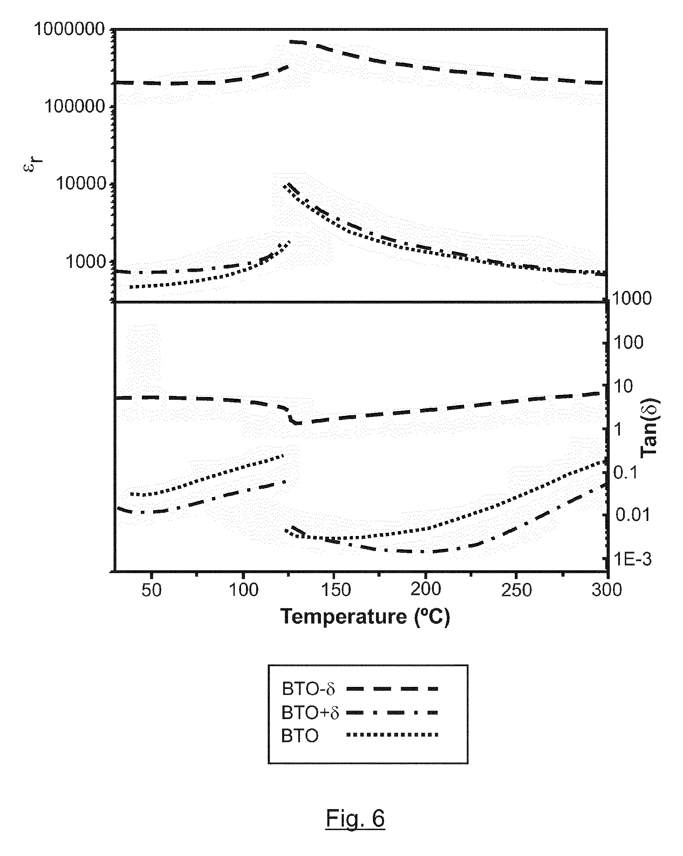

According to another embodiment of the present invention, the semiconductor material of the electromechanically active layer (2) is oxygen-reduced barium titanate ($BaTiO_{3-\delta}$, henceforth labelled as $BTO_{-\delta}$). The sample used to obtain the graph of Fig. 6 was a single crystal of (001)-oriented barium titanate ($BaTiO_3$, henceforth labelled as BTO), having a dimensions of 10 mm long, 1 mm wide and 0.46 mm thick. Measurements made on the as-received sample are referred to as BTO. Measurements made after reducing the as-received sample at 800 °C for 30 hours in mixture (5%) $H_2$ / (95%) $Ar_2$ atmosphere, are referred to as $BTO_{-\delta}$. Measurements made after reoxidizing the reduced sample, at 800 °C, for 30 hours in pure (99.9999%) $O_2$ atmosphere, are referred to as $BTO_{+\delta}$. The method for measuring the capacitive impedance and flexoelectric coefficient is, as described in [J. Narvaez and G. Catalan; "Origin Of the enhanced flexoelectricity of relaxor ferroelectrics", Appl. Phys. Lett. 104, 162903 (2014)]: a dynamic mechanical analyser connected to a lock-in amplifier was used to measure the bending-induced displacement current, and an LCR-meter was used to measure the capacitance and dielectric loss.

A peak, corresponding to the transition from cubic paraelectric to tetragonal ferroelectric, is observed around 125 °C for all three cases. However, the dielectric loss and dielectric constant of reduced $BTO_{-\delta}$ are orders of magnitude larger compared to fully oxidized BTO and $BTO_{+\delta}$. Both the high loss and giant dielectric constant are classic signatures of the Maxwell-Wagner effect (barrier layer capacitance), whereby increased conductivity inside the crystal results in high dissipation (loss tangent) and high capacitance due to the reduced thickness of the charge-depleted interfacial barrier barrier [H. Lu, C.-W. Bark, D. Esque de los Ojos, J. Alcala, C. B. Eom, G. Catalan, A. Gruverman; "Mechanical Writing of Ferroelectric Polarization", Science 336, 59-61 (2012)], [D. O'Neill, R. M. Bowman, J. M. Gregg; "Dielectric enhancement and Maxwell-Wagner effects in ferroelectric superlattice structures", Appl. Phys. Lett. 77, 1520 (2000)], [G. Catalan, J. F. Scott; "Magnetoelectrics-Is CdCr2S4 a multiferroic relaxor?" Nature 448 (7156), E4-E5 (2007)], [R. M. Glaister; "Barrier-layer dielectrics", Proceedings of the IEE - Part B: Electronic and Communication Engineering, Volume 109, p. 423 - 431 (1962)], [Derek C. Sinclair, Timothy B. Adams, Finlay D. Morrison, and Anthony R. West; "CaCu3Ti4O12: One-step internal barrier layer capacitor", Appl. Phys. Lett. 80, 2153 (2002)] and [W. Heywang; "Semiconducting Barium Titanate. J. Mater. Science. 6, 1214 (1971)]. The fact that the intrinsic dielectric properties of the as-received sample can be recovered upon reoxidation ($BTO_{+\delta}$) shows that the conductivity enhancement is purely due to vacancies and not to any other irreversible change in the sample.

The graph of Fig. 6 shows clearly how, when the crystal is turned into a semiconductor by oxygen reduction ($BTO_{-\delta}$), its effective permittivity (its capacitance) increases by a factor of more than 100 due to the barrier-layer or Maxwell-Wagner mechanism. This increase in capacitance explains why semiconductor materials can generate more charge in response to bending, because flexoelectricity is proportional to capacitance.

The effective flexoelectric coefficient (bending-induced polarization divided by strain gradient) is plotted as a function of temperature in Fig. 7. When comparing Fig.6 and Fig. 7, it can be seen immediately that the peaks in flexoelectricity and permittivity occur at the same critical temperature, Tc=125 °C for all three BTO, $BTO_{-\delta}$ and $BTO_{+\delta}$, and with an enhancement of flexoelectricity that mirrors that of the permittivity: the maximum effective flexoelectric coefficient for both as-received BTO and re-oxidized $BTO_{+\delta}$ are in the range of $\sim 20 - 30\ \mu C/m$, while the flexoelectric coefficient of oxygen-reduced barium titanate $BTO_{-\delta}$ is over two orders of magnitude bigger, and indeed larger than ever measured for any material [P. Zubko, G. Catalan and A. K. Taganstsev; "Flexoelectric Effect in Solids", Ann. Rev. Mater. Res. 43 (2013)].

The most important aspect of Fig. 7 is that the oxygen-reduced barium titanate $BTO_{-\delta}$, which is electrically conducting, presents an effective flexoelectric coefficient that is more than 100 times bigger than that of the fully oxidized (insulating) BTO and $BTO_{+\delta}$. The enhancement of flexoelectricity for semiconductors compared to insulators, however, is a general feature and not unique to BTO, as justified in the discussion above and experimentally validated by the large flexoelectric coefficient of semiconductor silicon.

**Claims**

1. Flexoelectric device, comprising:

   - an electromechanically active layer (2) with a first side (2a) and a second side (2b);
   - a first electrode (3) arranged on the first side (2a); and
   - a second electrode (4) arranged on the second side (2b);

   **characterized in that** the electromechanically active layer (2) is made of a semiconductor material capable of generating a voltage (V) between the two electrodes (3, 4) when it is bent.

2. Flexoelectric device according to claim 1, wherein the electromechanically active layer (2) also comprises:

   - a first charge-depleted insulating barrier (5a) between the first side (2a) and the first electrode (3); and
   - a second charge-depleted insulating barrier (5b) between the second side (2b) and the second electrode (4).

3. Flexoelectric device according to any of claims 1 to 2, wherein the device has a capacitor structure.

4. Flexoelectric device according to any of claims 1 to 3, wherein the semiconductor material is silicon.

5. Flexoelectric device according to claims 3 and 4, wherein the capacitor structure is formed by a single-crystal silicon wafer with platinum electrodes (3, 4) deposited onto the opposite sides of said wafer.

6. Flexoelectric device according to any of claims 1 to 3, wherein the semiconductor material is either n-type or p-type doped silicon.

7. Flexoelectric device according to any of claims 1 to 3, wherein the semiconductor material is a vacancy-doped oxide dielectric.

8. Flexoelectric device according to any of claims 1 to 3, wherein the semiconductor material is oxygen-reduced or n-type doped barium titanate.

Fig. 1A

Partially-relaxed
Piezoelectric
Strain

Un-relaxed
Piezoelectric
Strain

Passive layer

Macroscopic
bending moment

Fig. 1B

Fig. 2A

Fig. 2B

Fig. 2C

Fig. 3A

Deformation at the unit cell level

Microscopic bending moment

Fig. 3B

Fig. 4A

Fig. 4B

Fig. 4C

Fig. 5

Fig. 6

Fig. 7

Europäisches
Patentamt

European
Patent Office

Office européen
des brevets

## EUROPEAN SEARCH REPORT

Application Number

EP 15 38 2491

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/055257 A1 (SHAW-KLEIN LORI J [US]) 8 March 2012 (2012-03-08) | 1-3,5,7,8 | INV. H01L41/09 H01L41/00 |
| A | * paragraphs [0027], [0028], [0087]; claims 16, 18; figures 5, 6 * ----- | 4,6 | H02N2/18 H01L41/187 H01L41/18 |
| X | JP 2014 235095 A (SEIKO INSTR INC) 15 December 2014 (2014-12-15) | 1,4-6 | |
| A | * paragraph [0025] - paragraphs [0027], [0032]; figures 1, 2 * ----- | 2,3,7,8 | |

TECHNICAL FIELDS
SEARCHED      (IPC)

H01L
H02N

The present search report has been drawn up for all claims

| Place of search | Date of completion of the search | Examiner |
|---|---|---|
| Munich | 4 April 2016 | Angermeier, Detlef |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 15 38 2491

This annex lists the patent family members relating to the patent documents cited in the above-mentioned European search report.
The members are as contained in the European Patent Office EDP file on
The European Patent Office is in no way liable for these particulars which are merely given for the purpose of information.

04-04-2016

| Patent document cited in search report | Publication date | Patent family member(s) | Publication date |
|---|---|---|---|
| US 2012055257 A1 | 08-03-2012 | US 2012055257 A1<br>WO 2012033837 A2 | 08-03-2012<br>15-03-2012 |
| JP 2014235095 A | 15-12-2014 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **L.E. CROSS.** Flexoelectric effects: Charge separation in insulating solids subjected to elastic strain gradients. *J. Mater. Sci.,* 2006, vol. 41, 53-63
- **P. ZUBKO ; G. CATALAN ; A. K. TAGANSTSEV.** Flexoelectric Effect in Solids. *Ann. Rev. Mater. Res.,* 2013, 43
- **A. VON HIPPEL.** Dielectrics and Waves, London. Artech House, 1995
- **D. O'NEILL ; R. M. BOWMAN ; J. M. GREGG.** Dielectric enhancement and Maxwell-Wagner effects in ferroelectric superlattice structures. *Appl. Phys. Lett.,* 2000, vol. 77, 1520
- **G. CATALAN ; J. F. SCOTT.** Magnetoelectrics-Is CdCr2S4 a multiferroic relaxor?. *Nature,* 2007, vol. 448 (7156), E4-E5
- **DEREK C. SINCLAIR ; TIMOTHY B. ADAMS ; FINLAY D. MORRISON ; ANTHONY R. WEST.** CaCu3Ti4O12: One-step internal barrier layer capacitor. *Appl. Phys. Lett.,* 2002, vol. 80, 2153
- **R. M. GLAISTER.** Barrier-layer dielectrics. *Proceedings of the IEE - Part B: Electronic and Communication Engineering,* 1962, vol. 109, 423-431
- **E. V. BURSIAN ; N.N. TRUNOV.** Nonlocal piezoelectric effect. *Sov. Phys. Sol. State,* 1974, vol. 16, 760
- **P. ZUBKO ; G. CATALAN ; A. K. TAGANSTSEV;.** Flexoelectric Effect in Solids. *Ann. Rev. Mater. Res.,* 2013, 43
- **A.K. TAGANTSEV ; A.S. YURKOV.** Flexoelectric effect in finite samples. *J. Appl. Phys.,* 2012, vol. 112, 044103
- **M. STENGEL.** Microscopic response to inhomogeneous deformations in curvilinear coordinates. *Nature Communications,* 2014, vol. 4, 2693
- **Y. A. GENENKO ; O. HIRSCH ; P. ERHART.** Surface potential at a ferroelectric grain due to asymmetric screening of depolarization fields. *J. Appl. Phys.,* 2014, vol. 115, 104102
- **W. HEYWANG.** Semiconducting Barium Titanate. *J. Mater. Science,* 1971, vol. 6, 1214
- **T. KOLODIAZHNYI ; A. PETRIC ; M. NIEWCZAS ; C. BRIDGES ; A. SAFA-SEFAT ; J. E. GREEDAN.** Thermoelectric power, Hall effect, and mobility of n-type BaTiO. *Phys. Rev. B,* 2003, vol. 68, 085205
- **J. NARVAEZ ; G. CATALAN.** Origin Of the enhanced flexoelectricity of relaxor ferroelectrics. *Appl. Phys. Lett.,* 2014, vol. 104, 162903
- **H. LU ; C.-W. BARK ; D. ESQUE DE LOS OJOS ; J. ALCALA ; C. B. EOM ; G. CATALAN ; A. GRUVERMAN.** Mechanical Writing of Ferroelectric Polarization. *Science,* 2012, vol. 336, 59-61